# EUROPÄISCHE PATENTANMELDUNG

(11) **EP 2 093 036 A2**
(43) Veröffentlichungstag der Anmeldung: **26.08.2009**
(21) Anmeldenummer: 09152782.0
(22) Anmeldetag: 13.02.2009
(51) Int. Cl.: B28D 5/00

(54) **Verfahren zum mechanischen Strukturieren von flexiblen Dünnschichtsolarzellen und eine hierfür geeignete Vorrichtung**

(30) Priorität: 22.02.2008 DE 102008010783
(71) Anmelder: JENOPTIK Automatisierungstechnik GmbH, 07745 Jena (DE)
(72) Erfinder: Zühlke, Hans-Ulrich, 07743 Jena (DE); Reichl, Torsten, 98553 Schleusingen (DE); Eberhardt, Gabriele, 07749 Jena (DE); Henning, Roland, 07749 Jena (DE)
(74) Vertreter: Schaller, Renate

(57) **Zusammenfassung**

Die Erfindung betrifft ein Verfahren und eine Vorrichtung zur mechanischen Strukturierung von Dünnschichtsolarzellen 2, die gemeinsam auf einer flexiblen Trägerschicht 1 mit ihrem Schichtaufbau vorgefertigt in Form einer Materialbahn vorliegen. Erfindungsgemäß wird die Materialbahn auf einer Auflage 4 gehalten, wobei Grabenbereiche (b), in denen zur Strukturierung mit einem mechanischen Ritzwerkzeug Gräben 3 eingebracht werden, auf eine elastische Unterlage gezogen werden, indem über die angrenzenden grabenfreien Bereiche (a) die Materialbahn kraftschlüssig gehalten wird.

## Beschreibung

Die mechanische Strukturierung in den Schichtaufbau von Dünnschichtsolarzellen mit rigiden Trägerschichten wie Glas oder Aluminium ist bekannt und technologisch gemeistert. Unter dem Strukturieren wird das Einbringen von Gräben unterschiedlicher Tiefen in den Schichtaufbau und parallel zu den Außenkanten der Dünnschichtsolarzellen verstanden, um einzelne Schichten elektrisch miteinander zu verbinden bzw. sie voneinander zu isolieren. Üblicherweise werden zwei Gräben mit einem möglichst geringen Abstand zueinander pro Dünnschichtsolarzelle erzeugt.

Meist werden hierzu druckgeregelte Nadelhalter mit speziell geformten Nadelspitzen verwendet, wie z. B. in der EP 1 544 172 A1 beschrieben. Es werden dabei keine besonderen Anforderungen an die Werkstückauflage bzw. den Werkstückhalter gestellt, da die Trägerschicht selbst eine harte und feste Unterlage für die zu strukturierenden Schichten darstellt und die Trägerschicht von der Strukturierung unbeeinflusst bleibt.

Für Dünnschichtsolarzellen, hergestellt in Dünnschichttechnologie, dient die Trägerschicht ausschließlich als Träger für die aufgebrachten Funktionsschichten. Anstelle von starren Materialien wie Glas, können hierfür vorteilhaft auch flexible Schichten wie Kunststofffolien oder Metallfolien verwendet werden.

Dünnschichtsolarzellen mit flexiblen Trägerschichten eröffnen nicht nur breitere Einsatzmöglichkeiten, sondern lassen sich auch durch die Möglichkeit der Bearbeitung und Aufbewahrung in Rollenform großflächiger herstellen.

Dem Wettbewerbsvorteil, insbesondere gegeben durch die Flexibilität und das geringe Gewicht derartiger Dünnschichtsolarzellen, stehen erschwerte Bedingungen bei der Strukturierung gegenüber.

In der Beschreibung des Standes der Technik der DE 10 2004 016 313 A1 wird dargelegt, dass das mechanische Ritzen für Dünnschichtsolarzellen, die durch Deposition auf flexiblem Material entstanden sind, weniger geeignet ist. Im Gegensatz zu Glas, was alternativ als Material für die Trägerschicht verwendet werden kann, würden flexible Trägermaterialien dem Druck der Ritznadel nachgeben und haben eine weniger ebene Oberfläche, sodass das mechanische Ritzen mit größeren Problemen behaftet sei. Diese Probleme umgehend wird in der DE 10 2004 016 313 A1 ein Laserverfahren zum Trennen und Strukturieren vorgeschlagen.

Aus dem Stand der Technik bekannte Verfahren zum mechanischen Strukturieren beschäftigen sich im Wesentlichen mit der Optimierung des Werkzeuges. Zur Werkstückauflage werden keine Aussagen getroffen.

Üblicherweise werden eine Vielzahl von Dünnschichtsolarzellen gemeinsam auf einer Trägerschicht hergestellt, die dann nach Fertigstellung der Dünnschichtsolarzellen aufgetrennt wird, um die Dünnschichtsolarzellen voneinander zu separieren.

Zur Herstellung einer Vielzahl rechteckförmiger Dünnschichtsolarzellen ist der für die Dünnschichtsolarzellen vorgesehene Schichtaufbau entweder ganzflächig oder bevorzugt in Form vorgebildeter Dünnschichtsolarzellen auf der Trägerschicht in einem rasterförmigen Muster aufgetragen, bei dem die Kanten der vorgebildeten Dünnschichtsolarzellen zueinander und zur Kante der Materialbahn parallel und rechtwinklig verlaufen. Entsprechend können die mit der Strukturierung einzubringenden Gräben in die vorgebildeten Dünnschichtsolarzellen sämtlich in der gleichen Richtung eingebracht werden, womit eine gemeinsame Strukturierung noch im Verbund vor der Separierung, durch Trennung des Trägermaterials, von Vorteil ist.

Dünnschichtsolarzellen mit flexiblen Trägerschichten werden vorzugsweise als wickelbare Materialbahn vorgefertigt und verarbeitet. Die Materialbahn wird dann abschnittsweise zwischen dem Abwickeln und dem Aufwickeln bearbeitet. Die Materialbahn kann aber auch in einer Länge vorliegen, wie sie einem bearbeitbaren Materialbahnabschnitt entspricht.

Bei den nachfolgenden Erläuterungen soll von dem praktischen Fall ausgegangen werden, dass die Materialbahn eine vielfache Bahnlänge gegenüber der Bahnbreite aufweist und abschnittsweise bearbeitet werden soll.

Die zum Einbringen von Gräben notwendige Relativbewegung zwischen dem Werkzeug und der Materialbahn als Werkstück kann sowohl in Richtung der Bahnlänge (Bahnrichtung) als auch rechtwinklig hierzu erfolgen, um parallele Gräben zwischen zwei der späteren Außenkanten der Dünnschichtsolarzellen zu erzeugen.

Zum mechanischen Einbringen der Gräben ist es bekannt, einzelne Ritznadeln oder auch Nadelkämme mit einer Vielzahl, gegebenenfalls im Abstand zueinander verstellbaren Ritznadeln als Werkzeug zu verwenden. Der Stand der Technik offenbart für die Ausführung der Ritznadeln unterschiedliche Geometrien, unterschiedliche Ritzwinkel mit denen die Ritznadeln über das Werkstück geführt werden sowie unterschiedliche Maßnahmen um die Ritznadeln auf das Werkstück, gegebenenfalls mit einer geregelten Kraft, zu drücken. Es ist aus dem Stand der Technik kein Hinweis gegeben, dass spezielle Maßnahmen bezüglich der Auflage des Bahnmaterial getroffen werden.

Der Erfindung liegt die Aufgabe zu Grunde, ein Verfahren zu schaffen, mit dem Dünnschichtsolarzellen mit einer flexiblen Trägerschicht mit hoher Qualität mechanisch strukturiert werden können.
Eine weitere Aufgabe der Erfindung ist es, eine für das Verfahren geeignete Vorrichtung zu schaffen.

Die Aufgabe wird für ein Verfahren mit den Merkmalen des Anspruches 1 und für eine Vorrichtung mit den Merkmalen des Anspruches 2 gelöst.

Vorteilhafte Weiterbildungen sind in den Unteransprüchen beschrieben.

Anhand der Zeichnung wird die Vorrichtung im Folgenden beispielhaft näher erläutert.

Es zeigen:

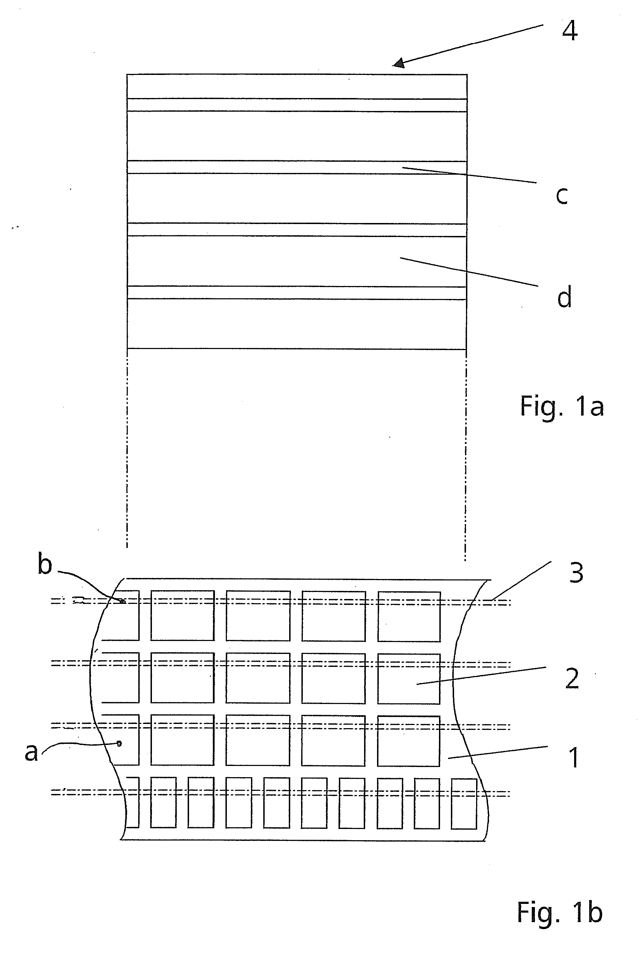

- Fig. 1a: eine Auflage für den zu bearbeitenden Materialbahnabschnitt
- Fig. 1b: einen Materialbahnabschnitt, wie er zur Bearbeitung mit Hilfe der Auflage gemäß Fig. 1a ausgebildet ist.

Mit dem erfindungsgemäßen Verfahren sollen auf einer flexiblen Trägerschicht 1 mit ihrem Schichtaufbau vorgefertigte Dünnschichtsolarzellen 2 strukturiert werden. Die Trägerschicht 1 liegt in Form einer Materialbahn vor, die über ihre Länge auf einer Rolle aufgerollt ist und auf der die vorgefertigten Dünnschichtsolarzellen 2 mit ihren späteren Kanten, die mit der Separierung der Dünnschichtsolarzellen 2 nach dem Strukturieren entstehen, parallel zu den Bahnkanten angeordnet sind.

Ein Beispiel für eine solche Materialbahn ist in Fig. 1b gezeigt.

Auf einer flexiblen Trägerschicht 1 sind vier Reihen von Dünnschichtsolarzellen 2 mit ihrem fertigen Schichtaufbau aufgetragen. Beispielhaft sollen drei Reihen Dünnschichtsolarzellen 2 mit den gleichen Abmessungen z. B. 20 mm x 20 mm umfassen, während die vierte Reihe durch Dünnschichtsolarzellen 2 geringerer Abmessungen z. B. 10 mm x 10 mm gebildet wird.

Da die Gräben 3 zur Strukturierung parallel zu zwei sich gegenüberliegenden Kanten der Dünnschichtsolarzellen 2 verlaufen sollen, können die Gräben 3 über die gesamte Länge der Materialbahn sämtlich entweder parallel zu einer Seitenkante der Trägerschicht 1 oder hierzu rechtwinklig eingebracht werden.

In diesem Beispiel sollen die Gräben 3 parallel zu den seitlichen Kanten der Trägerschicht 1 verlaufen und sind als Strichlinien dargestellt. Der Abstand zwischen den beiden jeweils über eine Dünnschichtsolarzelle 2 verlaufenden Gräben 3, nachfolgend Grabenpaar genannt, beträgt nur ca. 100 µm -150 µm.

Aus den vorgegebenen Größen für die einzelnen Dünnschichtsolarzellen 2 und Ihre Anordnung auf der Trägerschicht 1 ergibt sich, in welchen Abständen zueinander die Grabenpaare eingebracht werden müssen. Im vorliegenden Beispiel ergibt sich für die Breite der Trägerschicht 1 und damit die Breite der Materialbahn z. B. 80 mm und für den Abstand der Grabenpaare z. B. 22 mm, wenn man unterstellt, dass der Abstand zwischen den Dünnschichtsolarzellen 2 gleich 2 mm ist.

Um die Materialbahn zu bearbeiten, wird diese von einer ersten Rolle abgewickelt, über eine Auflage 4 geführt, auf welcher die Materialbahn nacheinander abschnittsweise während der Bearbeitung fixiert wird und anschließend auf einer zweiten Rolle aufgewickelt. Die Länge und die Breite des fixierten Materialbahnabschnittes sind durch die Abmessungen der Auflage 4 bestimmt.

Zum Einbringen der Gräben 3 wird ein Ritzwerkzeug oberhalb des fixierten Materialbahnabschnittes relativ zur Materialbahn entweder parallel zur Materialbahnkante oder rechtwinklig zu dieser geführt.
Das Ritzwerkzeug kann eine einzelne Ritznadel oder ein Ritzkamm, bestehend aus mehreren auf einer gerade angeordneten und bevorzugt in ihrem Abstand zueinander verstellbaren Ritznadeln sein.

Die erforderliche Relativbewegung zwischen dem Ritzwerkzeug und der Materialbahn kann, wie bereits erwähnt, grundsätzlich eine lineare Bewegung entweder parallel oder rechtwinklig zur Materialbahnkante und damit zur Wickelrichtung der Materialbahn ausgeführt werden, um mit dem Ritzwerkzeug Gräben 3 in den Schichtaufbau zur Strukturierung der vorgefertigten Dünnschichtsolarzellenmodule zu erzeugen.

Für eine Relativbewegung rechtwinklig zur Materialbahnkante wird der auf der Auflage 4 fixierte Materialbahnabschnitt ortsfest gehalten und das Ritzwerkzeug wird über die Breite des Materialbahnabschnittes geführt.
Für eine Relativbewegung parallel zur Materialbahnkante kann analog das Ritzwerkzeug über die Länge des Materialbahnabschnittes geführt werden.
In beiden Fällen muss entweder die Wickelbewegung unterbrochen werden oder es müssen zusätzliche Maßnahmen getroffen werden, um trotz konstanter Wickelgeschwindigkeit einen Materialbahnabschnitt vorübergehend ortsfest zu halten. Üblicherweise werden hierzu zusätzliche Pufferrollen eingesetzt, die durch Anheben und Absenken den Materialbahnweg zwischen der ersten und der zweiten Rolle verändern.

Für eine Relativbewegung parallel zur Materialbahnkante, wie es im beschriebenen Ausführungsbeispiel vorgesehen ist, kann ebenfalls das Ritzwerkzeug bewegt werden oder es wird die Materialbahn bewegt. Hierfür kann vorteilhaft die Wickelbewegung genutzt werden. Erfindungsgemäß führt hierzu die Auflage 4 selbst eine Bewegung in Wickelrichtung durch, was an späterer Stelle noch genauer ausgeführt werden soll.

Erfindungswesentlich für das Verfahren ist es, dass der zu bearbeitende Materialbahnabschnitt über grabenfreie Bereiche a, das sind Streifen in die keine Gräben 3 eingebracht werden, auf der Auflage 4 kraftschlüssig gehalten wird und über angrenzende Grabenbereiche b, das sind Streifen die im Wesentlichen durch die Grabenpaare abgedeckt werden, auf eine elastische Unterlage gezogen wird.
Die Unterteilung des Materialbahnabschnittes in grabenfreie Bereiche a und Grabenbereiche b ist durch die Anordnung und Dimensionierung der vorgefertigten Dünnschichtsolarzellen 2 und damit der Lage der Gräben 3 vorgegeben, das heißt die Abstände der Grabenbereiche b zueinander entsprechen den Abständen der einzubringenden Grabenpaare.

Um die Materialbahn abschnittsweise wie beschrieben auf einer Auflage 4 zu halten, ist die Auflage 4, bestimmt durch ihre doppelte Funktion, in Ritzbereiche c und Haltebereiche d unterteilt, wobei die Ritzbereiche c nicht schmaler sind als ein Grabenpaar breit ist und die Ritzbereiche c zueinander angeordnet sind gleich der Anordnung der Grabenpaare zueinander. Die Haltebereiche d entsprechen in der Größe und der Anordnung zueinander der Größe und der Anordnung der grabenfreien Bereiche a auf der Materialbahn. Eine solche Auflage 4 ist in Fig. 1a dargestellt.

Die Ritzbereiche c werden durch Streifen aus einer elastischen Unterlage z. B. aus einem thermoplastischen Elastomer gebildet. Damit wird zum einen gegenüber üblichen metallischen Auflagen ein höherer Haftreibkoeffizient zwischen der Trägerschicht 1 und Auflage 4 in den Ritzbereichen c geschaffen und zum anderen, wird die beim Ritzen der Gräben 3 durch die Bearbeitungskräfte in die Trägerschicht 1 eingebrachte Energie teilweise durch die elastische Unterlage aufgenommen. Damit wird ein Zusammenschieben der Trägerschicht 1 in Bearbeitungsrichtung und ein damit entstehender sogenannter Stick-Slip Effekt vermieden, der immer dann zwischen zwei aneinanderliegenden Körpern auftritt, wenn die Haftreibung durch den Energieeintrag überwunden wird. Das Ritzwerkzeug kann mit einer höheren Andruckkraft über den Schichtaufbau der vorgefertigten Dünnschichtsolarzellen 2 geführt werden. Die Gräben 3 vorbestimmter Tiefe können somit in einer besseren Qualität und nur einer bzw. weniger Überfahrten erzeugt werden als mit üblichen Standardauflagen aus Metall.

Die Haltebereiche d sollen die Trägerschicht 1 in dem aufliegenden Materialbahnabschnitt auf der Auflage 4 kraftschlüssig fixieren.
Unabhängig vom Material der Trägerschicht 1 bietet sich hierfür ein Ansaugen mittels Unterdruck an. Zu diesem Zweck sind die Haltebereiche d als Ansaugflächen ausgebildet, die über eine Vielzahl von Ansaugöffnungen oder ein poröses Material, z. B. geschäumtes Aluminium oder geschäumter Edelstahl, mit einer Vakuumkammer verbunden sind.

Bei einer metallischen Trägerschicht 1 bietet sich ein Halten durch Magnetkraft an.

Die Haltebereiche d werden entsprechend durch Magnetstreifen gebildet. In diesem Fall kann die Auflage 4 vorteilhaft als ein umlaufendes Förderband ausgebildet sein, sodass der Materialbahnabschnitt zwar auf der Auflage 4 fixiert ist, aber gleichzeitig auch mittels eines mit dem Förderband verbundenen Antriebes auf die Wickelgeschwindigkeit abgestimmt in Wickelrichtung bewegt wird. Idealweise werden die zweite Rolle zum Aufwickeln der Materialbahn und das Förderbahn synchron mit einem Antrieb angetrieben. Eine solche Lösung ist besonders vorteilhaft, wenn die Erzeugung der Gräben 3 mit nur einer Überfahrt des Ritzwerkzeuges erfolgt. Das Ritzwerkzeug kann dann ortfest gehalten werden. Das Ritzwerkzeug wird vorteilhaft durch zwei Ritzkämme gebildet, die jeweils eine in Nadelanzahl und Nadelabstand identische Nadelgruppe aufweisen und zueinander um den Abstand der eine Grabengruppe bildenden Nadeln versetzt sind.

### Bezugszeichenliste

- 1: Trägerschicht
- 2: Dünnschichtsolarzelle
- 3: Graben
- 4: Auflage

- a: grabenfreier Bereich
- b: Grabenbereich
- c: Ritzbereich
- d: Haltebereich

## Patentansprüche

1. Verfahren zum mechanischen Strukturieren von Dünnschichtsolarzellen (2), die gemeinsam auf einer flexiblen Trägerschicht (1) mit einem Schichtaufbau vorgefertigt in Form einer Materialbahn vorliegen, welche auf einer Auflage (4) gehalten wird, bei dem ein Ritzwerkzeug relativ zur Auflage (4) linear bewegt wird, um in vorgegebenen Grabenbereichen (b) der Materialbahn Gräben (3) in den Schichtaufbau zu ritzen, wobei die Materialbahn über zwischen den Grabenbereichen (b) liegende Haltebereiche kraftschlüssig auf der Auflage (4) gehalten wird und die Grabenbereiche (b) auf elastische Unterlagen gezogen werden.

2. Verfahren nach Anspruch 1, **dadurch gekennzeichnet,**
**dass** die Materialbahn nach dem Abwickeln von einer ersten Rolle und vor dem Aufwickeln auf eine zweite Rolle über die Auflage (4) geführt und dort abschnittsweise gehalten wird.

3. Vorrichtung zum mechanischen Strukturieren von Dünnschichtsolarzellen (2), die gemeinsam auf einer flexiblen Trägerschicht (1) mit einem Schichtaufbau vorgefertigt in Form einer Materialbahn vorliegen, durch Ritzen von Gräben (3), die parallel oder rechtwinklig zu einer Seitenkante der Materialbahn mit einem vorgegebenen Abstand zueinander angeordnet sind,
mit einer Auflage (4), auf der die Materialbahn wenigstens abschnittsweise während des Ritzens aufliegt, wobei die Auflage (4) Ritzbereiche (c) aufweist, die gleich der Anordnung der Gräben (3) zueinander angeordnet sind und aus einem elastischen Material bestehen und zwischen den Ritzbereichen (c) Haltebereiche (d) vorhanden sind, über die der Materialbahnabschnitt auf der Auflage (4) kraftschlüssig gehalten wird,
mit einem Ritzwerkzeug und
mit Mitteln zum relativen Bewegen des Ritzwerkzeugs zur Materialbahn entlang der Gräben (3).

4. Vorrichtung nach Anspruch 3, **dadurch gekennzeichnet,**
**dass** die Haltebereiche (d) durch Ansaugflächen gebildet werden, die mit einer Vakuumeinrichtung verbunden sind.

5. Vorrichtung nach Anspruch 3, **dadurch gekennzeichnet, dass** die Haltebereiche (d) durch Magnetbänder gebildet werden.

6. Vorrichtung nach Anspruch 4, **dadurch gekennzeichnet,**
**dass** die Auflage (4) ein umlaufendes Förderband darstellt und die Mittel zum relativen Bewegen einen Antrieb des Förderbandes darstellen.

7. Vorrichtung nach Anspruch 3, **dadurch gekennzeichnet,**
**dass** das elastische Material der Ritzbereiche (c) ein thermoplastisches Elastomer ist.
